# EUROPEAN PATENT APPLICATION

(11) **EP 1 343 176 A1**
(43) Date of publication of application: **10.09.2003**
(21) Application number: 01982875.5
(22) Date of filing: 20.11.2001
(51) Int. Cl.: H01B 5/14, C23C 16/40, H01L 31/04

(54) **CONDUCTIVE FILM, PRODUCTION METHOD THEREFOR, SUBSTRATE PROVIDED WITH IT AND PHOTOELECTRIC CONVERSION DEVICE**

(30) Priority: 21.11.2000 JP 2000355006; 15.11.2001 JP 2001350208
(71) Applicant: Nippon Sheet Glass Co., Ltd., Osaka-shi, Osaka 541-8559 (JP); KANEKA CORPORATION, Osaka-shi, Osaka 530-8288 (JP)
(72) Inventor: Fujisawa, Akira, c/o Nippon Sheet Glass Co., Ltd, Osaka-shi, Osaka 541-8559 (JP); Nara, Masatoshi, c/o Nippon Sheet Glass Co., Ltd, Osaka-shi, Osaka 541-8559 (JP); Sueyoshi, Yukio, c/o Nippon Sheet Glass Co., Ltd, Osaka-shi, Osaka 541-8559 (JP); Hirata, Masahiro, c/o Nippon Sheet Glass Co., Ltd, Osaka-shi, Osaka 541-8559 (JP)
(74) Representative: Power, Philippa Louise
(86) International application number: JP0110148
(87) International publication number: WO02043079

(57) **Abstract**

A conductive film which is formed on a substrate, wherein a total of areas of the base surfaces of protrusions at least 250 nm in height is at least 5% of the area of a surface on which this conductive film is formed. The conductive film mainly contains at least one kind of compound out of tin oxide, titanium oxide, indium oxide and zinc oxide, and is formed on a transparent substrate by a chemical vapor deposition using an oxygen atom-containing material as vapor. A photoelectric conversion device is formed by a conductive film-carrying substrate and at least one photoelectric conversion layer disposed on the substrate and containing a crystalline silicon thin film 1-5 µm in thickness.

## Description

### Technical Field

The present invention relates to conductive films used in photoelectric conversion elements and the like, and also relates to methods for manufacturing those conductive films, substrates provided with those conductive films, and photoelectric conversion devices using those substrates.

### Background Art

Recent energy and environmental issues have led to an increased interest in solar cells. From the standpoint of conserving resources, thin-film type solar cells are likely to become mainstream. The following is a general configuration of a thin-film type solar cell. A transparent conductive film made of tin oxide (SnO₂), for example, a photoelectric conversion layer made of an amorphous semiconductor such as amorphous silicon or amorphous silicon germanium, and a rear surface electrode are layered, in that order, on a transparent substrate such as a glass sheet.

For solar cells, there is a demand for increased photoelectric conversion efficiency, and various technologies have been developed for that purpose. A representative example of such a technology is that for providing a transparent conductive film with a rough surface. Accordingly, light that is incident on that surface is scattered, increasing the length of the optical path in the photoelectric conversion layer.

For example, JP S62-7716B discloses an amorphous silicon solar cell provided with a transparent electrode made of fine particles with an average particle diameter of 0.1 to 2.5 µm. JP H2-503615A discloses a solar cell substrate provided with a conductive film having projections with diameters from 0.1 to 0.3 µm and a height/diameter ratio of 0.7 to 1.2. JP H4-133360A discloses a photovoltaic device provided with a tin oxide thin film having projections in the shape of truncated pyramids with a height of 100 to 300 nm and in which the angles between normal lines and the principle surface of the substrate are 30° to 60°. JP H3-28073B discloses a photovoltaic device provided with translucent conductive oxides having an average particle diameter of approximately 50 to 200 nm, a height difference of approximately 100 to 500 nm, and a spacing between projections of approximately 200 to 1000 nm.

With all of these solar cells, the premise is that amorphous silicon is used for the photoelectric conversion layer. Amorphous silicon is well suited for the photoelectric conversion layer of solar cells because even at a thin film thickness it exhibits a high photoelectric conversion efficiency.

However, optical deterioration is a problem with amorphous silicon because the irradiation of light generates defects, resulting in a drop in the conversion efficiency of the solar cell in an initial period of light irradiating. For this reason, recently solar cells have been developed in which a thin film made of microcrystalline silicon or thin-film polycrystalline silicon (hereinafter, these are referred to in general as "crystalline silicon"), with which optical deterioration does not easily occur, is used in place of amorphous silicon as the photoelectric conversion layer. Here, crystalline silicon is used to refer to silicon that is at least 50% crystalline by volume, and it may include non-crystalline portions in parts thereof.

However, crystalline silicon has a slightly smaller light absorption coefficient than amorphous silicon, and thus it is necessary to increase the film thickness of the photoelectric conversion layer in order to maintain a photoelectric conversion efficiency on a par with that of amorphous silicon. On the other hand, increasing the thickness of the crystalline silicon thin film facilitates peeling at the interface between the conductive film and the crystalline silicon thin film (reported at the 28th IEEE Photovoltaic Specialist Conference). This film peeling is thought to occur as the result of differences in thermal expansion coefficient between the conductive film and the crystalline silicon thin film.

### Disclosure of Invention

The present invention was arrived at in view of such problems innate in the conventional technology.

A conductive film of the present invention is formed on a substrate, and a total area of a base surface of projections at least 250 nm high occupies at least 5% of an area of a surface on which the conductive film is formed.

According to a manufacturing method of the present invention, the above conductive film is formed on a substrate by a thermal decomposition method. A substrate with conductive film of the present invention includes the above conductive film and a substrate, and the conductive film is formed on the substrate. A photoelectric conversion device of the invention includes this substrate with conductive film and at least one photoelectric conversion layer arranged on the substrate with conductive film.

### Brief Description of Drawings

Fig. 1 is a diagram that schematically shows an embodiment of the present invention.

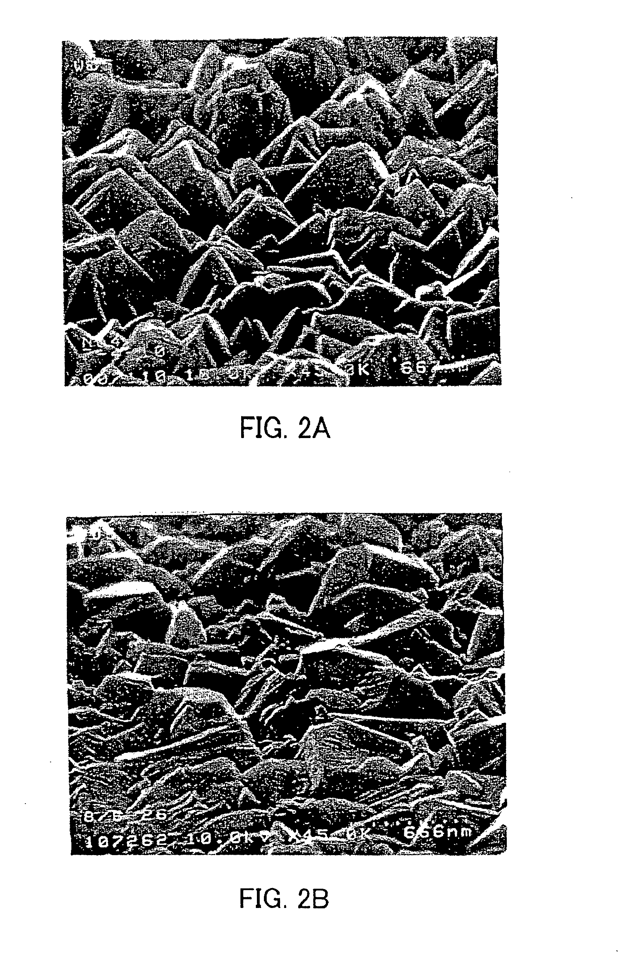

Fig. 2 is a diagram showing the appearance of an example of the conductive film surface of the present invention observed by a scanning electron microscope (SEM), where Figs. 2A and 2B are diagrams in which the transparent conductive films of Working Examples 3 and 4, respectively, are captured at a magnification of 45,000 times.
Fig. 3 schematically shows an example of a device for forming the conductive film of the present invention on a glass ribbon through chemical vapor deposition (hereinafter referred to as "CVD").

### Embodiments of the Invention

Embodiments of the invention are explained below, however, the invention is not limited to the following explanation.

According to the invention, the occupation percentage of projections that are at least 250 nm high is 5% or more and preferably 10% or more, thus increasing the adhesion strength between the conductive film and the crystalline silicon thin film, making it difficult for interface peeling to occur. At present, the technological basis behind why it becomes difficult for interface peeling to occur is not fully understood. However, one explanation is that a type of anchoring effect is at work when crystals of the crystalline silicon thin film start to grow from deep in the recesses of the conductive film. The greater the number of projections that have a height of at least 250 nm, the larger the anchoring effect that can be anticipated.

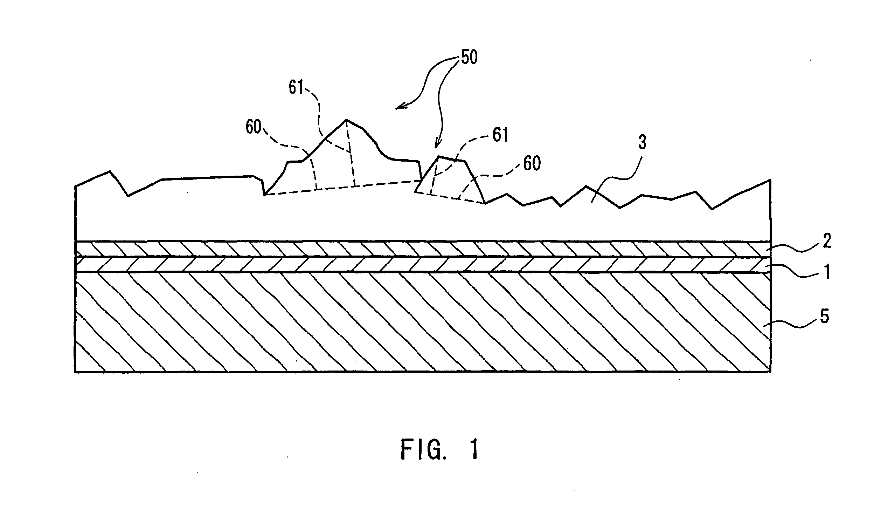

Here, as shown in Fig. 1, the height of the projections is defined as the length of perpendicular lines 61, which are drawn from the vertex of projections 50 to a base line 60 of the projections. Fig. 1 is a cross-sectional view that schematically shows a fabricated substrate with conductive film based on a photograph captured by a SEM. The height of the projections is calculated by drawing the base line and the perpendicular line for each projection based on the SEM photograph of the conductive film surface captured at an elevation angle of 30°. The area of the bottom surface of the projections is calculated with the length of the base line of the projections serving as its diameter. The area of the bottom surface of each projection recognized as at least 250 nm high is added up. The "occupation percentage" referred to in this specification is the percentage of the total value of the area of the bottom surfaces of the projections recognized as at least 250 nm high relative to the area of the surface on which the conductive film captured in the SEM photograph is formed. It should be noted that the area of the surface on which the conductive film is formed is equivalent to the area of the surface of the substrate or the undercoating film, however, the area is determined with the substrate, for example, assumed to be a flat surface.

At least 5% of the area should be occupied by projections that are at least 250 nm high for the anchoring effects to be exhibited. However, when this percentage is 70% or more, the relatively large projections crowd together, making it difficult for the crystalline silicon thin film to reach deep into the recesses of the conductive film, and this causes gaps (voids) between the conductive film and the crystalline silicon thin film. Consequently, the occupation percentage of projections with a height of 250 nm or more is preferably 5% to 70% and particularly preferably 10% to 50%.

If the substrate is a transparent substrate, then the haze ratio of the substrate with conductive film is preferably at least 15%. The haze ratio is a value that is proportionate to the degree of scattering of the transmitted light, and the larger the haze ratio, the greater the number of recessions and protrusions in the surface of the conductive film. It also indicates that the amplitude of the recessions and protrusions is large. Consequently, a conductive film with a high haze ratio is good at scattering transmission light at its surface, and thus effectively exhibits a light-trapping effect. By forming a crystalline silicon thin film on a conductive film with a high haze ratio, a photoelectric conversion element not prone to optical deterioration and with a high conversion efficiency is obtained.

If projections at least 250 nm high are present in at least 5% of the area, then the haze ratio of the conductive film can be set to 15% or more by appropriately selecting the manufacturing method and the manufacturing conditions. Moreover, the haze ratio can be established at 30% or more by setting the manufacturing conditions so that the projections are present in at least 10% of the area.

The conductive film is preferably a crystalline thin film, so that numerous relatively large projections are formed in its surface. The crystalline thin film more specifically can have as its main component at least one species selected from the group consisting of tin oxide, titanium oxide, indium oxide, and zinc oxide. Here, "main component," as it is usually defined, refers to a component that occupies at least 50wt%. Consequently, when "main component" is used, the addition of trace components is not excluded. Of the group mentioned above, a tin oxide thin film doped with fluorine or antimony is most preferable because of its low sheet resistance, high transmittance, and the ease with which the film is formed, for example. A preferable concentration of fluorine in the thin film is 0.15wt% or less. The refractive index of this thin film is approximately 1.9. It should be noted that the conductive film may also include other components in trace amounts, including silicon, aluminum, zinc, copper, indium, bismuth, gallium, boron, vanadium, manganese, and zirconium. However, it is preferable that the concentration of these trace components is not more than 0.02wt%.

Specifically, the sheet resistance of the conductive film is preferably 5 to 30 Ω/□ (square). In consideration of this value, the film thickness of the conductive film is preferably 500 to 2000 nm. In a preferable embodiment of the invention, if the conductive film is not more than 1500 nm, and even if it is not more than 1000 nm, the occupation percentage of projections at least 250 nm high can be maintained at 5% or more.

The conductive film can be formed directly on the substrate surface. However, if the substrate is a glass sheet, for example, then there is a risk that alkaline components in the glass will migrate to the surface due to moisture or heat and alter the properties of the conductive film. Accordingly, as shown in Fig. 1, interlayers (hereinafter, referred to as "undercoating films") 1 and 2 can be provided between a substrate 5 and a conductive film 3. The undercoating films are not limited to a single layer, and may be constituted by two or more layers. If the undercoating films are constituted by two or more layers, then it is preferable that the first undercoating layer 1, which is in contact with the glass sheet, has a film thickness of 5 to 100 nm and includes as its main component at least one species selected from the group consisting of tin oxide, titanium oxide, zinc oxide, and aluminum oxide. The second undercoating layer 2, which provides the surface on which the conductive film is formed, preferably has a film thickness of 5 to 100 nm and includes as its main component at least one species selected from the group consisting of silicon oxide, aluminum oxide, and tin oxide. On the other hand, if the undercoating film is a single layer, then the second undercoating layer may be used instead of the first undercoating layer. If the undercoating film is too thin it will not be able to adequately stop the diffusion of alkaline components, whereas if it is too thick, then new problems occur, such as a drop in the transmittance or a greater likelihood that the undercoating film will peel.

Although so-called physical deposition methods such as sputtering, ion-plating, and vacuum deposition can be used to form the conductive film and the undercoating film, it is preferable that a so-called chemical deposition method such as CVD or a spray method, which fall under the category of thermal decomposition methods (methods for forming films that are accompanied by the thermal decomposition of the raw material for forming the film), is used. Physical deposition methods result in excellent homogeneity in film thickness. However, in consideration of manufacturing efficiency during mass-production and the durability of the thin film, chemical deposition methods, which are accompanied by a thermal decomposition reaction of the raw material, are superior. With physical deposition methods, the range of the film formation conditions at which numerous relatively large projections can be formed is narrow, making it difficult to find a suitable range for them. Although large projections can be formed by increasing the film thickness when a physical deposition method is used, doing so results in new problems like those seen in undercoating films, namely peeling of the conductive film and a drop in the transmittance.

Examples of spray methods include a solution spray method in which a solution containing metallic compounds is sprayed onto a high-temperature glass sheet, a dispersion liquid spray method in which a dispersion liquid where fine particles of metallic compounds are dispersed within a fluid is used in place of a solution, and a powder spray method in which the powder of metallic compounds is used in place of a solution. By contrast, with CVD, vapor for forming thin films including at least tin, titanium, indium, or zinc, for example, is used.

Spray methods are advantageous in that they can be carried out using relatively simple devices. However, they are prone to variation in the film thickness of the thin film because it is difficult to control the liquid droplets and the product material that should be discharged (such as reaction products and non-decomposed residue, for example). Also, defects in the glass become larger. Therefore, taking these points into consideration, CVD is overall the most suitable method for fabricating both the conductive film and the undercoating film.

The formation of the conductive film and the undercoating film through CVD can be achieved by spraying raw material in a gaseous state onto a glass sheet that has been cut to a predetermined size and heated. For example, a conductive film and an undercoating film can be yielded by placing a glass sheet on a mesh belt and sending it through a heating furnace while supplying the raw material so as to react the raw material on the surface of the glass sheet, which is heated to a predetermined temperature. However, from the standpoint of energy efficiency, a preferable method is forming a film by supplying the raw material onto a molten glass ribbon within a tin float bath during the glass manufacturing process by the float method so as to react the raw material using the heat of the glass itself (hereinafter, referred to as an "on-line CVD method"). On-line CVD is extremely advantageous for forming films on large-area substrates, and is particularly suited for the formation of conductive films for large-area photoelectric conversion devices, such as roof material. Using this method allows films to be formed on the surface of a glass ribbon with a temperature that is higher than the softening point of glass, and thus the film performance, the film formation reaction speed, and the film formation reaction efficiency can be increased. Moreover, the occurrence of defects such as pinholes (holes in the film) also can be inhibited.

The temperature of the substrate, such as a glass sheet, when forming conductive films and undercoating films through CVD is preferably 590°C or higher and even more preferably 615°C or higher. Films can be formed easily in such elevated temperatures through on-line CVD.

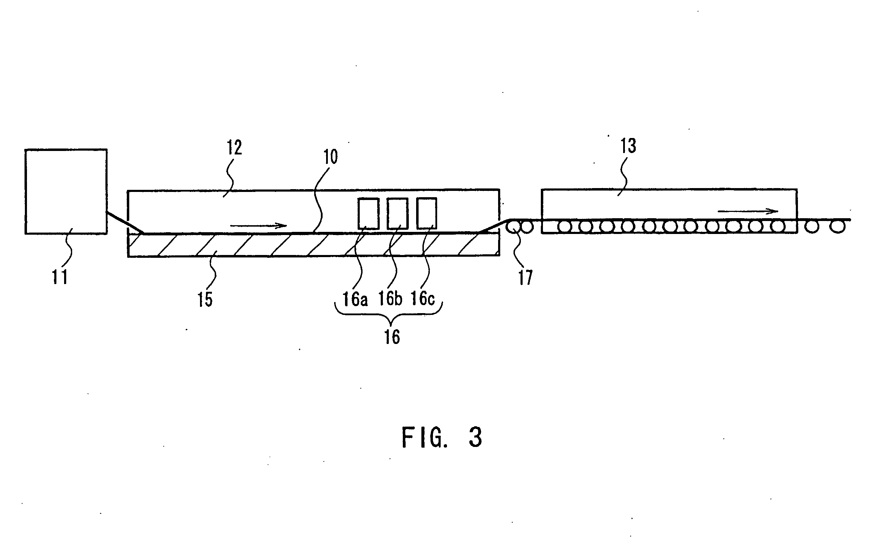

Fig. 3 shows an example of a device for on-line CVD. With this device, a glass ribbon 10 flows from a melting furnace (furnace for a float method) 11 into a tin float bath (tank) 12 and is moved in a belt-like manner over a tin bath 15. A predetermined number of coaters 16 (in the configuration of the drawing, there are three coaters 16a, 16b, and 16c) are disposed within the tin float bath at a predetermined distance from the surface of the glass ribbon 10. Raw material is supplied from these coaters in a gaseous state, forming a contiguous thin film on the glass ribbon 10. Employing a plurality of coaters allows an undercoating film and a conductive film to be formed contiguously on the glass ribbon 10 by CVD. The glass ribbon 10 on which the thin films, including the conductive film, have been formed is raised up by rollers 17 and delivered into an annealing furnace 13. It should be noted that the glass ribbon cooled in the annealing furnace 13 is cut into glass sheets of a predetermined size by a cutting device not shown in the drawing.

The formation of films on the glass ribbon can be carried out using on-line CVD and a spray method in unison. For example, by employing on-line CVD and a spray method in that order, it is specifically possible to achieve a predetermined laminated structure by forming a film through CVD within the space of the tin float bath and then forming a film through a spray method on the downstream side, in the direction in which the glass ribbon proceeds, of the tin float bath space.

It is also possible to form a relatively flat conductive film through a spray method or sputtering and then process its surface through etching or blasting to yield unevenness, obtaining a conductive film surface of which at least 5% is constituted by projections at least 250 nm high. Such treatment in a separate after-step is good in that the shape of the projections can be controlled with extreme precision. However, it also leads to an increase in manufacturing costs. Thus, on-line CVD in which the film formation conditions have been adjusted is best suited for cases in which it is necessary to form a homogenous conductive film over a large area.

When using CVD to form a conductive film or an undercoating film whose main component is tin oxide as the raw material for the tin, it is possible to use tin tetrachloride, dimethyltin dichloride, dibutyltin dichloride, tetramethyltin, tetrabutyltin, dioctyltin dichloride, monobutyltin trichloride, or dibutyltin diacetate, for example. Of these, dimethyltin dichloride and dibutyltin dichloride are particularly preferable. Oxygen, water vapor, or dry air, for example, can be used as the oxidizing agent necessary for forming tin oxide from these raw materials for tin. If fluorine is used to dope the tin oxide film, then hydrogen fluoride, trifluoroacetate, bromotrifluoromethane, and chlorodifluoromethane, for example, can be used as the raw material for fluorine. If antimony is used as the dopant, then antimony pentachloride or antimony trichloride, for example, can be used as the antimony source.

If CVD is used to form a conductive film and an undercoating film having titanium oxide, indium oxide, or zinc oxide, for example, as its main component, then a chloride of that metal (such as titanium tetrachloride or zinc dichloride) can be used in place of the raw material for tin.

If a thin film having silicon oxide as its main component is formed through CVD as an undercoating film, then monosilane, disilane, trisilane, monochlorosilane, dichlorosilane, 1,2-dimethylsilane, 1,1,2-trimethyldisilane, 1,1,2,2-tetramethyldisilane, tetramethyl orthosilicate, or tetraethyl orthosilicate, for example, can be used as the raw material for silicon. Examples of the oxidizing agent in this case include oxygen, water vapor, dry air, carbon dioxide, carbon monoxide, nitrogen dioxide, and ozone, for example. It should be noted that if silane is used, then an unsaturated hydrocarbon gas such as ethylene, acetylene, or toluene can be used in conjunction therewith for the purpose of preventing reaction of the silane before it reaches the glass surface.

Similarly, if a thin film with aluminum oxide as its main component is formed through CVD as an undercoating film, then examples of the raw material for the aluminum include trimethylaluminum, aluminum triisopropoxide, diethylaluminum chloride, aluminum acetylacetonate, and aluminum chloride. In this case, examples of the oxidizing agent include oxygen, water vapor, and dry air.

To form numerous projections with a height of 250 nm or more in the surface of the conductive film using CVD, the water vapor concentration within the raw material gas can be increased and the thermal decomposition reaction be allowed to proceed under high temperatures. Furthermore, the projections can be enlarged by lowering the oxygen concentration in the raw material gas. The effect due to lowering the oxygen concentration is even more conspicuous when the water vapor concentration of the raw material gas is less than 30mol%. The water vapor concentration can be higher than the oxygen concentration. A metal such as tin can be oxidized using the water vapor as the oxygen atom containing compound with the largest concentration, that is, as the oxidizing agent with the largest concentration, in the raw gas material. The oxygen concentration is preferably low at not more than 15mol% and even more preferably not more than 10mol%. However, taking the transmittance of the conductive thin film into account, it is preferably at least 5mol%. On the other hand, the water vapor concentration is preferably 20mol% to 80mol%. The heat of the molten glass ribbon can be harnessed to make the thermal decomposition reaction proceed under high temperatures, and from this standpoint, on-line CVD is a film-formation method suited for a case in which numerous relatively large projections are formed. The preferable manufacturing method and manufacturing conditions for the conductive film can be applied, without change, to form the undercoating film.

By disposing the conductive film on various types of substrates known in the art, it functions as an electrode or as an infrared radiation reflecting film. There are no particular limitations regarding the substrate type, and examples include transparent insulating substrates such as glass sheets and resin sheets. If the conductive film is formed on a glass sheet, then it is particularly useful as an electrode for a photoelectric conversion element or as a solar reflecting film for window glass. As mentioned above, one characteristic of this conductive film is that interface peeling is not prone to occur, and thus the conductive film is suited for applications that require a layered thin film. For example, due to the fact that solar cells are set outside, they must be highly waterproof and able to resist the heat of solar energy. To continually maintain sufficient photoelectric conversion efficiency over long periods of time under these harsh environmental conditions, the adhesive strength between the thin films exhibiting the various functions is important. A conductive film that exhibits a high haze ratio contributes to improving the photoelectric conversion efficiency in the photoelectric conversion element because it effectively exhibits the ability to trap light. Consequently, this conductive film is best suited for use as the transparent electrode of a solar cell, although this does not preclude its use in other applications.

A case in which this conductive film is used in a photoelectric conversion element is described in detail below. When a photoelectric conversion layer constituted by an amorphous silicon or crystalline silicon thin film, for example, and a rear surface electrode are formed in that order on a conductive film of a substrate with conductive film, a photoelectric conversion element is obtained. Also, a device that incorporates the photoelectric conversion element and includes various related components provided as a unit for extracting electrical energy from light energy to serve as a solar cell, for example, is known as a photoelectric conversion device.

The photoelectric conversion layer may be a single layer or a plurality of layers, and moreover it may be a conventional amorphous silicon thin film or a crystalline silicon thin film. Furthermore, it may also be a so-called tandem thin film that combines an amorphous silicon thin film and a crystalline silicon thin film. In the case of a tandem thin film, ordinarily an amorphous silicon thin film is formed on the conductive film and a crystalline thin film is formed on the amorphous silicon thin film. With the surface of an amorphous silicon thin film, the unevenness in the surface of the conductive film is leveled out, and thus in order to increase the strength of the adhesion between the amorphous silicon thin film and the crystalline silicon thin film, it is essential that the conductive film is provided with large projections. This conductive film is able to exhibit the effect of preventing interface peeling regardless of whether the photoelectric conversion layer formed above it is an amorphous silicon thin film or a crystalline silicon thin film. However, crystalline silicon thin films are inherently not prone to interface peeling, and thus a crystalline silicon thin film matches particularly well with this conductive film.

An amorphous silicon thin film is formed by depositing p-type, i-type, and n-type semiconductor layers in that order by plasma CVD. A specific example is a film formed by depositing a p-type microcrystalline silicon-based layer doped with boron, which is a conduction-type determining impurity atom, to at least 0.01at%, an intrinsic non-crystalline silicon layer as the photoelectric conversion layer, and an n-type microcrystalline silicon-based layer doped with phosphorus, which is a conduction-type determining impurity atom, to at least 0.01%, in that order. These layers are not limited to the above description, and it is also possible to use an amorphous silicon-based layer for the p-type layer or to use aluminum, for example, as the impurity atom in the p-type microcrystalline silicon-based layer. It is also possible to use an alloy material such as amorphous or microcrystalline silicon carbide or silicon germanium as the p-type layer. It should be noted that the film thickness of the conduction-type (p-type, n-type) microcrystalline silicon-based layers is preferably 3 to 100 nm and more preferably 5 to 50 nm. The film thickness of the intrinsic amorphous silicon layer is preferably 0.05 to 0.5 µm. However, with a photoelectric conversion element provided with an amorphous silicon thin film, it is also possible to use an amorphous silicon carbide layer (for example, an amorphous silicon carbide layer made of amorphous silicon containing carbon at not more than 10at%) or an amorphous silicon germanium layer (for example, an amorphous silicon germanium layer made of amorphous silicon containing germanium at not more than 30at%), which are alloy materials, in place of the intrinsic amorphous silicon layer. The intrinsic amorphous silicon layer is preferably formed through plasma CVD with a base temperature of not more than 450°C. This layer is formed as a substantially intrinsic semiconductor thin film in which the density of the conduction-type determining impurity atoms is not more than 1×10¹⁸ cm⁻³.

The crystalline silicon thin film can be formed by depositing p-type, i-type, and n-type semiconductor layers in that order through plasma CVD using the same procedure as that used for the amorphous silicon thin film. Alternatively, it can be formed through electron beam deposition in which silicon is the raw material, plasma CVD using glow discharge in which monosilane diluted by hydrogen gas serves as the raw material, or thermal CVD using either monosilane or dichlorosilane. The film thickness of the crystalline silicon thin film is preferably 0.1 to 10 µm, and is even more preferably 5 µm or less. Because this thin film is formed through plasma CVD under a low temperature of not more than 450°C, for example, it contains a relatively large number of hydrogen atoms for terminating or inactivating the grain boundary or defects in the grains. The hydrogen content in the layer is preferably in a range of 0.5at% to 30at%, and even more preferably 10at% to 20at%.

In the case of a tandem-type photoelectric conversion element, the film thickness of the amorphous silicon thin film is preferably from 0.05 to 0.4 µm and the thickness of the crystalline silicon thin film is preferably from 0.5 to 5 µm and even more preferably from 1 to 3 µm, although this also depends on the configuration of the photoelectric conversion device.

Incidentally, the amorphous silicon thin film has a maximum spectral sensitivity in the wavelength range of roughly 500 to 600 nm, and due to its optical energy gap it is sensitive only up to a wavelength region of about 800 nm. On the other hand, the crystalline silicon thin film is sensitive up to about 1100 nm.

It is preferable that the rear surface electrode is formed through sputtering or vapor deposition of at least one metallic layer made of at least one material selected from aluminum (Al), silver (Ag), gold (Au), copper (Cu), platinum (Pt), and chromium (Cr). It is also possible to form a layer made of a conductive oxide such as indium-doped tin oxide (ITO), tin oxide (SnO₂), or zinc oxide (ZnO) between the photoelectric conversion element and the rear surface electrode.

It should be noted that compared to a photoelectric conversion element provided with an amorphous silicon thin film, a photoelectric conversion element provided with a crystalline silicon thin film has a lower generated open circuit voltage and a higher generated short circuit current density. For that reason, in a photoelectric conversion device provided with a crystalline silicon thin film, the transmittance of the conductive film has a greater effect on the photoelectric conversion efficiency of the device than does the sheet resistance of the conductive film.

### Working Examples

Hereinafter, Working Examples are used to describe the invention described in detail. However, the invention is not limited to the following examples.

### Working Examples 1 to 3

A 4 mm thick soda-lime glass sheet cut to 450×450 mm was placed on the mesh belt and sent through the heating furnace, heating it up to approximately 600°C. As the heated glass sheet was delivered, coaters arranged above the delivery route supplied a mixture gas A constituted by monosilane, oxygen, and nitrogen, forming a silicon oxide thin film (undercoating film) with a film thickness of 25 nm on the glass sheet. After cooling the glass sheet, it was once again placed on the mesh belt and sent through the heating furnace, heating it up to approximately 600°C. As the heated glass sheet was delivered, coaters arranged above the delivery route supplied a mixture gas B constituted by monobutyltin trichloride (vapor), oxygen, water vapor, nitrogen, and trifluoroacetate, forming a transparent conductive film made of fluorine-containing tin oxide (SnO₂:F) on the silicon oxide thin film. The composition ratio of the components in the mixture gas B was 0.5mol% of monobutyltin trichloride (vapor), 4mol% of oxygen, 33mol% to 42mol% of water vapor, 50.5mol% to 59.5mol% of nitrogen, and 3mol% of trifluoroacetate. The concentration of oxygen and water vapor in the mixture gas B is shown below in Table 1. It should be noted that changes in the concentration of the water vapor in Working Examples 1 to 3 were absorbed by changing the nitrogen concentration while the concentrations of the other components were kept the same. Also, the spacing between the coaters and the glass sheet was set to 10 mm, and the nitrogen gas was supplied in a curtain-like fashion to the side of the discharge portion so as to keep outside air from entering into the coaters during formation of the transparent conductive film.

A portion of this substrate with conductive film was cut away and the surface of the conductive film was captured at 45,000 X magnification (30° elevation angle) using a SEM, and the height and percentage occupied by of the projections in its surface was calculated. Also, using a portion of a separately prepared substrate with conductive film, the haze ratio was calculated with a haze meter. The results are shown below in Table 1.

A 3 µm thick crystalline silicon thin film was formed on the remaining cleaved substrates with conductive film through plasma CVD using monosilane and hydrogen as the raw materials. Then, a silver thin film (rear surface electrode) with a thickness of 300 nm was formed through electron beam deposition, yielding sample photoelectric conversion elements. These samples are of the general configuration of a solar cell whose photoelectric conversion layer is a crystalline silicon thin film. The photoelectric conversion efficiency of these samples was measured using conventional means, and with the measured value for Working Example 1 serving as the standard (standard value = 1.00), standardized values for these samples are shown in Table 1 below. In order to confirm the durability of the samples as solar cells, they were set in an incubator at 100% humidity and 80°C for 50 hours and then viewed using an SEM to determine whether peeling or cracking had occurred at the interface between the conductive film and the crystalline silicon thin film. The results are shown together in Table 1 below.

### Working Examples 4 and 5

Samples of photoelectric conversion elements were produced in the same manner as in Working Example 1 except that the composition ratio of the components in the mixture gas B was altered to 0.9mol% of tin tetrachloride (vapor), 35mol% to 37mol% of water vapor, 62mol% to 64mol% of nitrogen, and 0.06mol% of hydrogen fluoride, and the film thickness was changed to 810 to 840 nm. With respect to these samples, in the same manner as in Working Example 1, the height and the percentage occupied by the projections of the conductive film surface were calculated, the haze ratio was measured, and the photoelectric conversion efficiency and whether there was interface peeling was evaluated. The results are shown together in Table 1 below.

### Working Examples 6 and 7

Samples of photoelectric conversion elements were produced in the same manner as in Working Example 1 except that the thickness of the silicon oxide thin film on the glass sheet was changed to 50 nm and the oxygen concentration and the water vapor concentration of the mixture gas B and the thickness of the transparent conductive film were altered as shown in Table 1. With respect to these samples, in the same manner as in Working Example 1, the height and the percentage occupied by the projections of the conductive film surface were calculated, the haze ratio was measured, and the photoelectric conversion efficiency and whether there was interface peeling were evaluated. The results are shown collectively in Table 1 below.

### Working Examples 8 to 10

Using on-line CVD, samples of a photoelectric conversion element provided with a crystalline silicon thin film were produced. More specifically, the inside of the tin float bath was maintained at a pressure slightly higher than that outside the tank by supplying a gas mixture of 98% nitrogen by volume and 2% hydrogen by volume into the tin float bath, thereby maintaining a non-oxidizing atmosphere inside the tank, and a mixture gas C constituted by dimethyltin dichloride (vapor), oxygen, nitrogen, and helium was supplied from a first coater located on the most upstream side, forming a tin oxide thin film (first undercoating layer) with a film thickness of 35 nm on a glass ribbon. Next, a mixture gas a made of monosilane, ethylene, oxygen, and nitrogen was supplied from a second coater, forming a silicon oxide thin film (second undercoating film) with a film thickness of 25 nm on the tin oxide thin film. Then, a plurality of coaters arranged on the downstream side were used to supply a mixture gas *b* made of dimethyltin dichloride (vapor), oxygen, water vapor, nitrogen, helium, and hydrogen fluoride, forming an SnO₂:F thin film (transparent conductive film) on the silicon oxide thin film. The composition ratio of the components in the mixture gas *b* was 3.5mol% of dimethyltin dichloride (vapor), 7mol% to 42mol% of oxygen, 31mol% to 71mol% of water vapor, 1mol% to 50mol% of nitrogen, 17 mol% of helium, and 0.1mol% of hydrogen fluoride. In each Working Example the concentrations of the oxygen and the water vapor were changed, and the changes in these concentrations were absorbed by changing the nitrogen concentration while the concentrations of the other components remained the same.

With respect to this glass sheet, photoelectric conversion element samples were manufactured in the same manner as in Working Example 1, except that the thickness of the crystalline silicon thin film was set to 4 µm. For these samples, the height and the percentage occupied by the projections of the conductive film surface were calculated, the haze ratio was measured, and the photoelectric conversion efficiency and whether there was interface peeling were assessed. The results are shown in Table 1 below.

### Comparative Examples 1 to 3

A tin oxide thin film (first undercoating layer) with a film thickness of 25 nm was formed by supplying a mixture gas C' made of dimethyl dichloride (vapor), oxygen, nitrogen, and helium, through coaters under the same conditions as when the silicon oxide thin film was formed on the glass sheet in Working Example 1. After this glass sheet was cooled it was once again placed on the mesh belt and sent through the heating furnace, heating it to up to approximately 600°C. As the heated glass sheet continued to be delivered, coaters arranged above the delivery route supplied the mixture gas A, forming a silicon oxide thin film (second undercoating layer) with a film thickness of 15 nm on the tin oxide thin film. After the glass sheet was cooled it was once again placed on the mesh belt and sent through the heating furnace, heating it to up to approximately 600°C. As the heated glass sheet was delivered further, coaters arranged above the delivery route supplied the mixture gas B with the water vapor concentration and the oxygen concentration changed as shown below in Table 1, forming an SnO₂:F thin film (transparent conductive film) on the silicon oxide thin film. In the same manner as in Working Example 1, the height and the percentage occupied by the projections of the conductive film surface of this glass sheet were calculated.

A crystalline silicon thin film was then formed at a thickness of 4 µm under the same conditions as in Working Example 1, at which point interface peeling recognizable with the naked eye was confirmed over its entire surface. For this reason, it was not possible to measure the photoelectric conversion efficiency. The results are shown in Table 1 below.

**Table 1**

| | Oxygen Concen -tration (mol%) | Water Vapor Concen -tration (mol%) | Conductive Film Thickness (nm) | Occupation percentage of Projections 250 nm or Higher (%) | Haze Ratio (%) | Interface Peeling | Photoelectric Conversion Efficiency (%) |
|---|---|---|---|---|---|---|---|
| Working Ex. 1 | 4 | 33 | 1150 | 19 | 32 | no | 1.00 |
| Working Ex. 2 | 4 | 39 | 1200 | 25 | 35 | no | 1.01 |
| Working Ex. 3 | 4 | 42 | 1300 | 32 | 42 | no | 1.03 |
| Working Ex. 4 | 0 | 35 | 810 | 18 | 21 | no | 1.05 |
| Working Ex. 5 | 0 | 37 | 840 | 31 | 27 | no | 1.06 |
| Working Ex. 6 | 6 | 40 | 1200 | 14 | 26 | no | 0.99 |
| Working Ex. 7 | 7 | 31 | 1050 | 8 | 18 | no | 0.98 |
| Working Ex 8 | 33 | 40 | 890 | 6 | 11 | no | 1.02 |
| Working Ex. 9 | 7 | 71 | 1450 | 25 | 36 | no | 1.05 |
| Working Ex.10 | 42 | 31 | 770 | 12 | 10 | no | 1.03 |
| Comp. Ex. 1 | 5 | 18 | 750 | 4 | 13 | yes | not measurable |
| Comp. Ex. 2 | 10 | 17 | 800 | 3 | 11 | yes | not measurable |
| Comp. Ex. 3 | 18 | 16 | 700 | 1 | 10 | yes | not measurable |

The following points are understood by comparing the above Working Examples and comparative examples.

By comparing Working Examples 1 to 10 and Comparative Examples 1 to 3, it is clear that the lower the water vapor concentration in the raw gas when the transparent conductive film is formed through CVD, the more difficult it is for projections that are at least 250 nm high to form. Also, from Working Examples 4 and 5 it is clear that if the water vapor concentration in the raw gas for the conductive film is high, then the proportion of projections that are at least 250 nm increases, regardless of the type of the tin raw material.

By comparing Working Example 8 and Comparative Example 1, it is clear that peeling occurs in the interface between the transparent conductive film and the crystalline silicon thin film if projections that are at least 250 nm high do not constitute at least 5% of the surface of the transparent conductive film.

From Working Examples 8 through 10, it is clear that interface peeling does not occur even if a relatively thick 4 µm crystalline silicon thin film is provided, as long as the transparent conductive film is formed through on-line CVD. One explanation for this is that there are few temperature irregularities in the glass substrate when the transparent conductive film is formed, resulting in relatively uniform unevenness in the surface of the transparent conductive film. Consequently, if on-line CVD is used to form a transparent conductive film, then a photoelectric conversion device with a thick photoelectric conversion layer and high photoelectric conversion efficiency can be obtained.

According to the present invention, at least in the preferable embodiments thereof, a conductive film not prone to interface peeling is obtained, even if the layer formed directly above it, for example the crystalline silicon thin film, is thick. When a substrate provided with this conductive film is employed in a photoelectric conversion element, a solar cell with high photoelectric conversion efficiency and high durability is obtained.

The invention may be embodied in other forms without departing from the spirit or essential characteristics thereof. The embodiments disclosed in this application are to be considered in all respects as illustrative and not limiting. The scope of the invention is indicated by the appended claims rather than by the foregoing description, and all changes which come within the meaning and range of equivalency of the claims are intended to be embraced therein.

## Claims

1. A conductive film formed on a substrate, wherein a total area of a base surface of projections at least 250 nm high occupies at least 5% of an area of a surface on which the conductive film is formed.

2. The conductive film according to claim 1, wherein the total area of the base surface occupies at least 10% of the area of the surface on which the conductive film is formed.

3. The conductive film according to claim 1, wherein an undercoating film is formed on the substrate and the conductive film is formed on the undercoating film.

4. The conductive film according to claim 1, wherein a main component of the conductive film is at least one selected from the group consisting of tin oxide, titanium oxide, indium oxide, and zinc oxide.

5. The conductive film according to claim 1, wherein a sheet resistance of the conductive film is 5 to 30 Ω/□.

6. The conductive film according to claim 1, wherein a film thickness of the conductive film is 500 to 2000 nm.

7. The conductive film according to claim 6, wherein the film thickness is not more than 1500 nm.

8. A method for manufacturing the conductive film according to claim 1, wherein the conductive film is formed on a substrate by a thermal decomposition method.

9. The method for manufacturing a conductive film according to claim 8, wherein the thermal decomposition method is a chemical vapor method in which water vapor serves as a raw material containing a largest concentration of oxygen atoms.

10. A substrate with conductive film, comprising the conductive film according to claim 1 and a substrate, and wherein the conductive film is formed on the substrate.

11. The substrate with conductive film according to claim 10, wherein the substrate is a transparent substrate and the haze ratio of the substrate with conductive film is at least 15%.

12. The substrate with conductive film according to claim 11, wherein the haze ratio is at least 30%.

13. A photoelectric conversion device comprising:
the substrate with conductive film according to claim 10, and
at least one photoelectric conversion layer arranged on the substrate with conductive film.

14. The photoelectric conversion device according to claim 13, wherein the at least one photoelectric conversion layer includes a crystalline silicon thin film with a film thickness of 1 to 5 µm.
